# EUROPÄISCHE PATENTSCHRIFT

(11) **EP 4 299 154 B1**
(45) Veröffentlichungstag und Bekanntmachung des Hinweises auf die Patenterteilung: **03.09.2025**
(21) Anmeldenummer: 23182394.9
(22) Anmeldetag: 29.06.2023
(51) Int. Cl.: B01D 1/00, B01D 3/34, B01F 23/00, B01F 23/10, C23C 16/448

(54) **VERFAHREN UND VORRICHTUNG ZUR HOCHGENAUEN EINSTELLUNG VON DAMPFDRÜCKEN BEI DER HERSTELLUNG VON GASGEMISCHEN MITTELS VERDUNSTUNG EINER ODER MEHRERER ZU VERDUNSTENDEN FLÜSSIGKEITEN**
METHOD AND DEVICE FOR ADJUSTING VAPOUR PRESSURES WITH HIGH ACCURACY IN THE PRODUCTION OF GAS MIXTURES BY EVAPORATION OF ONE OR MORE LIQUIDS TO BE EVAPORATED
PROCÉDÉ ET DISPOSITIF POUR LE RÉGLAGE TRÈS PRÉCIS DE PRESSIONS DE VAPEUR LORS DE LA FABRICATION DE MÉLANGES GAZEUX PAR ÉVAPORATION D'UN OU PLUSIEURS LIQUIDES À ÉVAPORER

(30) Priorität: 01.07.2022 DE 102022116469
(43) Veröffentlichungstag der Anmeldung: 03.01.2024
(73) Patentinhaber: SKAN AG, 4123 Allschwil (CH)
(72) Erfinder: ZOSEL, Jens, 04736 Waldheim (DE); KLOCKOW, Andreas, 04736 Waldheim (DE); NOVÁK, Martin, 4123 Allschwil (CH)
(74) Vertreter: Maucher Jenkins Patent- und Rechtsanwälte

(56) Entgegenhaltungen:
- DE-A1- 102013 103 603
- US-A- 4 582 480
- US-A1- 2017 035 985

## Beschreibung

Die Erfindung betrifft eine Vorrichtung und ein Verfahren zur hochgenauen Herstellung von Gasgemischen aus Trägergas und Flüssigkeitsdampf mittels Verdunstung.

Hauptanwendungsgebiet der Erfindung ist die Kalibrierung von Gassensoren, die für die Steuerung und Zertifizierung pharmazeutischer, chemischer, biotechnologischer und elektronischer Prozesse benötigt werden.

Gasförmige Substanzen, die in Gasgemische in nur sehr geringen Konzentrationen (0-1000 Teile in einer Million, ppmv, Volumen-ppm) eingebracht werden sollen, und sich aus Flüssigkeiten verdampfen lassen, werden immer dann prozessnah in einen Trägergasstrom eingebracht, wenn Kondensation oder Sorptionsprozesse einer prozessfernen Präparation und anschließenden Lagerung in Druckgasbehältern entgegenstehen. Bei der prozessnahen/dezentralen Einbringung dieser Substanzen wird deren Konzentration in der Gasphase meist mit entsprechenden Gassensoren kontrolliert. Bei solchen Substanzen handelt es sich zum Beispiel um Wasserdampf, gasförmiges Wasserstoffperoxid, verschiedene Kohlenwasserstoffe wie Ethanol und Aceton oder auch Precursoren für die Atomlagenabscheidung bzw. auch andere Abscheideprozesse. Die Einstellung präziser Konzentrationen dieser verdunsteten oder verdampften Substanzen im unteren ppmv-Bereich ist häufig wegen verschiedener Randbedingungen nur mit eingeschränkter Genauigkeit möglich und muss daher häufig mit Gassensoren kontrolliert oder geregelt werden.

Zurzeit werden für die Einbringung von Dämpfen in Gasgemische verschiedene Verfahren in Form spezieller Vorrichtungen technisch genutzt, die fast immer für eine bestimmte Substanz optimiert werden mussten.

US 2017/035985 A1 beschreibt Befeuchtungseinrichtungen zur Verwendung mit Gastherapiesystemen. Insbesondere beschreibt die Druckschrift eine Befeuchtungsanordnung, die Folgendes umfasst: einen Gasdurchgang, der sich zwischen einem ersten Ort und einem zweiten Ort erstreckt, wobei der Gasdurchgang ein erstes Abteil und ein zweites Abteil umfasst, wobei jedes Abteil eine Feuchtigkeitsquelle umfasst, die so konfiguriert ist, dass sie Gasen in dem Gasdurchgang Feuchtigkeit hinzufügt, wobei jede Feuchtigkeitsquelle eine einstellbare Feuchtigkeitsabgabe hat; einen Sensor, der so ausgelegt ist, dass er eine oder mehrere Eigenschaften oder Substanzen eines Gasstroms erfasst; und ein Steuergerät, das so angepasst ist, dass es Daten von dem Sensor verwendet, um die einstellbare Feuchtigkeitsabgabe von mindestens einem der ersten und zweiten Abteile zu steuern, um eine Zielgaseigenschaft oder - substanz zu liefern, wobei das Steuergerät so angepasst ist, dass es einen Aktuator steuert, der einen freiliegenden Oberflächenbereich eines Reservoirs verändert.

DE102017102446A1 beschreibt ein Verfahren mit Variation der Dosierung eines Flüssigkeitsstroms der zu verdampfenden Flüssigkeit, bspw. Wasser, in einen Verdampfer, durch den ein Trägergas mit konstantem Volumenstrom strömt. Der Flüssigkeitsstrom wird bspw. erzeugt mittels thermischem Durchflussregler, Proportionalventil, Spritzenpumpe oder Membranpumpe. Im einfachsten Fall erfolgt das Verdampfen durch ein beheiztes Rohrstück. Dieses Verfahren lässt sich meist erst ab höheren Trägergasvolumenströmen über 1,5 SLM (Liter/min bei Normbedingungen) stabil einsetzen und ist zudem nur für solche Flüssigkeiten oder flüssigen Gemische einsetzbar, deren Inhaltsstoffe die kurzzeitige Erhitzung im Verdampfer unbeschadet überstehen. Es wird deshalb häufig für Wasser oder wässrige Gemische eingesetzt und ist zum Beispiel für die Einbringung von Wasserstoffperoxid ungeeignet, da dieses materialabhängig bereits ab Temperaturen von 50 °C einem erhöhten Zerfall in Wasserdampf und Sauerstoff bei der Verdampfung unterliegt. Eine weitere Einschränkung der Genauigkeit dieses Verfahrens besteht in der Forderung nach höchst präziser Kontrolle der Volumenströme des Trägergases und der dosierten zu verdunstenden Flüssigkeit, die beide die eingestellte Konzentration in hohem Maß beeinflussen. Zudem erfordert es eine hochkonstante Kinetik der Verdampfung, die bislang in den bekannten Geräten nur eingeschränkt verfügbar ist.

Webb (2001) beschreibt eine inzwischen seit vielen Jahrzehnten häufig eingesetzte Methode zur Einbringung von Dämpfen in Trägergase mittels apparativ sehr einfacher Gaseinleitung in die zu verdunstende Flüssigkeit über eine blasenbildende Fritte. Die Blasen durchströmen eine Flüssigkeitssäule und sättigen sich auf diesem Weg mit dem entsprechenden Dampf. Bei Austritt aus der Flüssigkeit zerplatzen diese Blasen dann und führen zu einer intensiven Aerosolbildung. Nachteiliger Weise verhindert diese Aerosolbildung eine präzise Einstellung des Dampfdrucks, so dass das Aerosol zuverlässig beseitigt werden muss, bevor das Gas/Dampf-Gemisch für eine Kalibrierung verwendet werden kann.

Klemm et al. (2011) offenbaren die Verdunstung über eine fließende Flüssigkeit-Gas-Grenzfläche (Falling film evaporation), um Dämpfe definiert in ein Trägergas zu überführen oder in Trägergase zu überführen. Diese Methode ist vor allem darauf optimiert, möglichst hohe Dampfkonzentrationen einstellen zu können. Für die genaue Einstellung geringer Dampfkonzentrationen ist sie ungeeignet.

Findley (1967) beschreibt ein Verfahren unter Nutzung einer porösen, rohrförmigen Membran, durch die das Trägergas strömt und durch deren Poren die Flüssigkeit in den Gasstrom verdunstet. Da dabei fast immer Mikroporen zum Einsatz kommen, wird z.T. beobachtet, dass sich Poren durch Bildung von Rückständen bei der Verdunstung zusetzen. Auch andere Alterungsvorgänge können an den Membranen auftreten, die ebenfalls zu einer veränderten Kinetik des Flüssig-Dampf-Übergangs und damit zu Ungenauigkeiten bei den im Gasgemisch erzeugten Dampfkonzentration führen. Auch dieses Verfahren wird häufig erst ab größeren Volumenströmen > 2 SLM eingesetzt und ist in seiner technischen Ausführung meist auch hochgradig vom Trägergasvolumenstrom abhängig.

Generell wird im Stand der Technik bei einer kinetischen Verdampfung (d.h. über dem Siedepunkt einer zu verdampfenden Flüssigkeit) auf kleiner Fläche geheizt. Das heißt, es wird viel Energie pro Fläche eingebracht. Dies führt oftmals zur Zersetzung temperatur-sensibler Substanzen und stört damit die hochpräzise Überführung dieser Substanzen in ein Gasgemisch.

DE 198 58 366 B4 zeigt ein Verfahren zum Herstellen und Abfüllen von quantitativ definierbaren Gasgemischen aus einem Trägergas mit mindestens einer weiteren Komponente in sehr geringer Konzentration mittels Durchleiten des erzeugten Gasstroms durch eine Falle zur Kondensation/Adsorption der mindestens einen weiteren Komponente. Nachteilig ist dabei, dass dieses Verfahren keine definierte Einstellung der Konzentration von mindestens einer weiteren Komponente erzielen kann.

US 2021 / 0060283 A1 offenbart eine Vorrichtung zur Befeuchtung von Luft mit mehreren Befeuchtungskammern, die physikalisch getrennt und bspw. über einen Schlauch miteinander verbunden sind oder in einem gemeinsamen Gehäuse angeordnet und mittels vertikaler Wände, die Gasdurchlässe aufweisen, so dass ein Gasfluss durch die mehreren Befeuchtungskammern gewährleistet wird. Nachteilig bei dieser Vorrichtung ist, dass kein definierter Dampfdruck eingestellt werden kann, da die Befeuchtungskammern sich nicht separat temperieren lassen und über die Wände zwischen den Kammern Wärme transportiert wird.

DE 10 2013 103 603 A1 zeigt einen sogenannten Bubbler zur Anreicherung eines Trägergases mit einem Präkursor. Nachteilig bei einer derartigen Vorrichtung ist, dass das Platzen der Blasen an der Flüssigkeitsoberfläche zu unerwünschten Aerosoltröpfchen in der Gasphase führt, die eine präzise Dampfdruckeinstellung verhindern.

DE 41 13 358 A1 offenbart eine Vorrichtung zur Mischung eines Trägergases mit einem Nutzgas, wobei die Vorrichtung zwei Behälter aufweist. In einem der Behälter befindet sich ein fester oder flüssiger Stoff aus dem das Nutzgas gewonnen wird und im zweiten Behälter erfolgt die Abscheidung des das Nutzgas bildenden Stoffes aus dem mit dem Nutzgas übersättigten und Trägergas. Nachteilig ist hier, dass an der großen inneren und unregelmäßigen Oberfläche der in den zweiten Behälter eingebrachten Formteile ungleichmäßige Abscheidetemperaturen entstehen. Für die Verdunstung von H₂O₂/H₂O-Gemischen ist diese Vorrichtung äußerst nachteilig, da H₂O₂ an dieser großen inneren Oberfläche in hohem Maß zersetzt würde.

Aufgabe ist es, ein Verfahren und eine Vorrichtung bereitzustellen, welche die Nachteile des Standes der Technik überwindet.

Die Erfindung soll die hochgenaue Kalibrierung von Gassensoren auch bei Volumenströmen von <2 Liter/min (bei Normbedingungen: 0 °C und 101325 Pa, Abkürzung der Einheit: SLM, d.h. entspricht <2 SLM) ermöglichen, insbesondere auch bei <1,5 SLM.

Das dafür nötige Gasgemisch soll dezentral, also anwendungsort-nah bereitgestellt werden können.

Insbesondere ist es nötig, die Dampfkonzentrationen der zu verdunstenden Flüssigkeit im Gasgemisch hochgenau einstellen zu können.

Möglichst im noch niedrigeren Volumenstrombereich unter 1 SLM sollen bei niedrigen Prozesstemperaturen unter 30 °C mit hoher Präzision sehr geringe Dampfkonzentrationen von unter 100 ppmv eingestellt werden können.

Erfindungsgemäß wird die Aufgabe mit der Erfindung gemäß den unabhängigen Ansprüchen gelöst. Vorteilhafte Ausgestaltungen der Erfindung sind in den abhängigen Ansprüchen angegeben.

Ausführungen für die erfindungsgemäße Vorrichtung gelten entsprechend auch für das erfindungsgemäße Verfahren und umgekehrt, und natürlich auch für die Verwendungen.

Gegenstand der Erfindung ist eine Vorrichtung zur Herstellung von Gasgemischen aus Trägergas und Flüssigkeitsdampf, wobei der Flüssigkeitsdampf H₂O₂ und Wasser umfasst, umfassend
- mindestens zwei benachbarte Verdunstungskammern ausgebildet zur Aufnahme einer zu verdunstenden Flüssigkeit, ausgewählt aus Wasser und einer wässrigen Wasserstoffperoxid-Lösung mit einer Konzentration im Bereich von 0,1 g/l bis 500 g/l, wovon jede einzeln temperaturregelbar ist, und die mindestens zwei Verdunstungskammern durch eine Wärmedämmung, die die Temperiereinheit der jeweiligen Verdunstungskammer umgibt, thermisch voneinander entkoppelt sind; und die Verdunstungskammern jeweils in horizontaler Aufstellrichtung segmentiert sind, indem jede Verdunstungskammer mindestens eine vertikale Wand mit einer Öffnung aufweist;
- jeweils eine Temperiereinheit an jeder der Verdunstungskammern, wobei die Temperiereinheit als Thermostatbad ausgebildet ist und eine Wanne und einen die Wanne verschließenden, temperierbaren Deckel umfasst, und
- Gasleitungen, welche eine Trägergasversorgung (bspw. einen Anschluss für Gasflasche oder Ähnliches) mit der ersten Verdunstungskammer verbinden, und welche die anderen Verdunstungskammern nacheinander miteinander verbinden und welche an der letzten Verdunstungskammer einen Auslass bereitstellen, sodass bei Benutzung das Trägergas durch die erste und von dort nacheinander durch die weiteren Verdunstungskammern, entlang der Oberfläche einer in der Verdunstungskammer befindlichen, zu verdunstenden Flüssigkeit geleitet wird.

Der Flüssigkeitsdampf weist eine zu verdunstende Flüssigkeit bzw. ihre Komponenten auf. In Ausführungsformen wird der Flüssigkeitsdampf durch die Verdunstung einer zu verdunstenden Flüssigkeit bzw. ihrer Komponenten gebildet. Komponenten der zu verdunstenden Flüssigkeit sind bspw. im Falle einer wässrigen Lösung als zu verdunstende Flüssigkeit in der zu wässrigen Lösung gelöste Komponenten.

Die Temperiereinheit an jeder einzelnen Verdunstungskammer umfasst sinnvoller Weise ein Thermostat zur Kühlung bzw. Heizung der Verdunstungskammer und einen Temperatursensor, der die jeweilige Temperatur in der Verdunstungskammer bestimmt. Die Temperiereinheit ist erfindungsgemäß als Thermostatbad, umfassend eine Wanne und einen die Wanne verschließenden, temperierbaren Deckel, ausgebildet. Wanne und/oder Deckel können in Ausführungsformen aus Edelstahl sein und der temperierbare Deckel Öffnungen zur Durchführung der Gasleitungen zu einem Einlass und einem Auslass der Verdunstungskammer aufweisen. Innerhalb des Thermostatbades ist ein Wärmeträger derart angeordnet, dass die Verdunstungskammer vollständig vom Wärmeträger umgeben ist. In Ausführungsformen ist zur Umwälzung des Wärmeträgers ein Rührwerk innerhalb des Thermostatbads angeordnet. In weiteren Ausführungsformen ist der Temperatursensor der Temperiereinheit innerhalb des Wärmeträgers angeordnet. Der Thermostat kann in Ausführungsformen als Peltierelement ausgebildet sein, welches unterhalb der Wanne des Thermostatbads angeordnet ist. Dies ermöglicht vorteilhaft die hochpräzise Temperatureinstellung in jeder einzelnen der mindestens zwei Verdunstungskammern auf ± 4 mK der einzustellenden Solltemperatur. Weiterhin verhindert der temperierbare Deckel vorteilhaft die Kondensation des Gasgemisches in den Gasleitungen bei der Überleitung in eine nachfolgende Verdunstungskammer. In weiteren Ausführungsformen sind die mindestens zwei Verdunstungskammern innerhalb eines Gehäuses angeordnet. Das Gehäuse kann eine Gehäusewanne und einen Gehäusedeckel umfassen. In weiteren Ausführungsformen sind die mindestens zwei Verdunstungskammern innerhalb des Gehäuses nebeneinander angeordnet, wobei die mindestens zwei Verdunstungskammern bevorzugt jeweils parallel nebeneinander angeordnet sein können. In Ausführungsformen sind die mindestens zwei Verdunstungskammern jeweils entlang ihrer Länge parallel nebeneinander angeordnet. Die Verdunstungskammern sind in Ausführungsformen rohrförmig mit verschlossenen Rohrenden als quer liegende Röhre ausgebildet, wobei die Rohrenden entlang der Länge oder auch der horizontalen Aufstellrichtung die quer liegende Röhre abschließen. Die rohrförmig ausgebildeten Verdunstungskammern weisen weiterhin Anschlüsse, wie einen Einlass und einen Auslass, zur Verbindung mit den Gasleitungen auf.

Thermisch voneinander entkoppelt im Sinne der Erfindung meint, dass die Temperatur der jeweiligen Verdunstungskammer allein durch die jeweilige der Verdunstungskammer zugeordnete Temperiereinheit beeinflusst wird und einstellbar ist. Eine gegenseitige Beeinflussung der Temperatur einer Verdunstungskammer durch benachbarte Verdunstungskammern, d.h. ein Wärmetransport von einer Verdunstungskammer zu einer benachbarten Verdunstungskammer, ist ausgeschlossen. Dazu sind die Verdunstungskammern durch eine Wärmedämmung thermisch voneinander entkoppelt. Die Wärmedämmung ist dabei erfindungsgemäß derart angeordnet, dass diese die Temperiereinheiten der jeweiligen Verdunstungskammern umgibt. In weiteren Ausführungsformen ist die Wärmedämmung ein Elastomerschaum und weist eine Dicke im Bereich von 3 mm bis 10 mm, bevorzugt 5 mm auf.

Die Gasleitung ist sinnvollerweise so ausgestaltet, dass sie jeweils (in Gasflussrichtung) an einem Einlass auf der einen (Längs-)Seite der Verdunstungskammer eintritt und auf der gegenüberliegenden (Längs-)Seite austritt, damit das Trägergas (bzw. die später erhaltenen zwischenzeitlich hergestellten Gasmischungen) möglichst über die ganze Fläche der zu verdunstenden Flüssigkeit, welche sich in den Verdunstungskammern befindet, strömen kann. In Ausführungsformen sind der Einlass und der Auslass entlang der Länge der Verdunstungskammer angeordnet, wobei jeweils der Einlass nahe eines ersten Endes einer rohrförmig ausgebildeten Verdunstungskammer und der Auslass nahe eines zweiten Endes einer rohrförmig ausgebildeten Verdunstungskammer angeordnet ist und sich das erste und das zweite Ende der rohrförmig ausgebildeten Verdunstungskammer entlang der Länge gegenüberliegen. Denn im Einsatz erlaubt die Vorrichtung folgende Arbeitsweise:
Das Trägergas strömt zuerst in eine erste Verdunstungskammer, über die Oberfläche der darin befindlichen zu verdunstenden Lösung, ohne diese aufzuwirbeln, von dort in unter Umständen weitere vorhandene, folgende Verdunstungskammern und schließlich in eine letzte Verdunstungskammer, an der sich auch ein Auslass für das fertige Gasgemisch befindet. Bei nur zwei Verdunstungskammern wäre also die zweite auch die letzte. In Ausführungsformen kann die Gasleitung am Auslass der letzten Verdunstungskammer einen Anschluss zur Zuführung des Trägergases aufweisen, um vorteilhaft eine Verdünnung des am Auslass der letzten Verdunstungskammer erhaltenen Gasgemisches zu ermöglichen.

Sinnvoller Weise handelt es sich also bei der zu verdunstenden Flüssigkeit um eine ruhende Flüssigkeit.

Jede der Verdunstungskammern enthält bei Benutzung die zu verdunstende Flüssigkeit und das Gas strömt lediglich über die Oberfläche der Flüssigkeit, ohne diese aufzuwirbeln oder durch sie hindurchgeleitet zu werden. In Ausführungsformen ist die zu verdunstende Flüssigkeit ausgewählt aus Wasser und einer wässrigen Lösung mit einer definierten Konzentration mindestens einer Komponente, die als Flüssigkeitsdampf in einen Trägergasstrom eingebracht werden soll. In weiteren Ausführungsformen ist eine wässrige Lösung mit einer definierten Konzentration mindestens einer Komponente bspw. eine wässrige Wasserstoffperoxid-Lösung definierter Konzentration. Die wässrige Wasserstoffperoxid-Lösung weist erfindungsgemäß eine Konzentration im Bereich von 0,1 g / l bis 500 g / I auf, bevorzugt 0,1 g / I bis 300 g / l, besonders bevorzugt 0,1 g / l bis 100 g / I und ganz besonders bevorzugt 0,1 g/ l bis 50 g / I.

Das Prinzip sei anhand einer beispielhaften Ausführung mit genau drei Verdunstungskammern erläutert: Mit der Erfindung wird bereits nach der ersten Verdunstungskammer ein Gasgemisch erhalten, welches 80 Ma-% der Soll-Menge der zu verdunstenden Flüssigkeit enthält. Nach Überleiten dieses Gasgemisches aus der ersten Verdunstungskammer durch die zweite (d.h. über die Oberfläche der darin enthaltenen zu verdunstenden Flüssigkeit) enthält das Gasgemisch weitere ca. 16% der Soll-Menge der zu verdunstenden Flüssigkeit (d.h. ca. 96%). Nachdem wiederum dieses Gasgemisch durch die dritte Verdunstungskammer geleitet wird, enthält es 100% der Soll-Menge der zu verdunstenden Flüssigkeit. Das heißt, das Gasgemisch entspricht dann der mittels der eingestellten Gleichgewichts-Temperatur gewählten Zusammensetzung.

Das heißt, erfindungsgemäß sind die Verdunstungskammern linear nacheinander miteinander über die Gasleitung verbunden.

Gegenstand der Erfindung ist ebenfalls ein Verfahren zur Herstellung von Gasgemischen aus Trägergas und Flüssigkeitsdampf, wobei der Flüssigkeitsdampf H₂O₂ und Wasser umfasst, insbesondere bevorzugt mittels der erfindungsgemäßen Vorrichtung, mit den Schritten:
a) Einstellung der Gleichgewichts-Temperatur des herzustellenden Gasgemisches als Sollwert in einer letzten
   von mindestens zwei einzeln temperaturregelbaren und durch eine Wärmedämmung, die die Temperiereinheiten der jeweiligen Verdunstungskammer umgibt, thermisch voneinander entkoppelten Verdunstungskammern, wobei die Verdunstungskammern in horizontaler Aufstellrichtung segmentiert sind, indem jede mindesteins eine vertikale Wand mit einer Öffnung ausweist, und wobei die Termperiereinheiten als Thermostatbad ausgebildet sind und eine Wanne und einen die Wand verschließenden, temperierbaren Deckel umfassen,
b) Einstellung eines Temperaturunterschieds von maximal 5 K zwischen jeweils benachbarten Verdunstungskammern, wobei die Temperatur in der ersten Verdunstungskammer die niedrigste, in der zweiten Verdunstungskammer die höchste und in der dritten Verdunstungskammer eine dazwischenliegende ist und der Gleichgewichtstemperatur des herzustellenden Gasgemisches entspricht, und
c) Leiten eines Trägergases mit einem Volumenstrom zwischen 0 und 2 l/min bei Normbedingungen durch die erste und von dort nacheinander durch die weiteren Verdunstungskammern, entlang der Oberfläche einer in den Verdunstungskammern befindlichen, zu verdunstenden Flüssigkeit (d.h. in aufsteigender Richtung von der ersten in Trägergas-Fließrichtung zur letzten hin, d.h. bei bspw. 3 Kammern von der ersten zur zweiten und danach zur dritten), wobei die zu verdunstende Flüssigkeit ausgewählt ist aus Wasser und einer wässrigen Wasserstoffperoxid-Lösung mit einer Konzentration im Bereich von 0,1 g/l bis 500 g/l, und wobei sich in der ersten Verdunstungskammer Wasser als zu verdunstende Flüssigkeit und in den weiteren Verdunstungskammern eine Wasser-H₂O₂-Mischung befindet..

Die "Einstellung" in den Schritten a) und b) erfolgt jeweils mittels der Temperiereinheit der jeweiligen Verdunstungskammer, sinnvoller Weise mittels Thermostat zur Kühlung/Heizung und Temperatursensor zur Bestimmung der IST-Temperatur in der jeweiligen Verdunstungskammer. D.h. "Einstellung" umfasst sowohl das Einstellen der SOLL-Temperatur, als auch das Messen der IST-Temperatur und auch das Heizen bzw. Kühlen auf die SOLL-Temperatur. Die Abweichung zwischen IST- und SOLL-Temperatur beträgt sinnvollerweise maximal ±10mK.

Als "letzte Verdunstungskammer" gilt die, welche den o.a. Auslass bereitstellt. Die Reihenfolge der Verdunstungskammern wird also in Richtung des Trägergas-Flusses bestimmt.

Bzgl. des Temperaturunterschieds in Schritt b): Hier sind verschiedene Temperaturabfolgen denkbar.

Für eine zu verdunstende Lösung mit nur einer Komponente, die in das Gasgemisch überführt werden soll, sind es, im Falle von bspw. genau drei Verdunstungskammern, max. 5 K zwischen erster und zweiter und zwischen zweiter und dritter Verdunstungskammer, wobei die erste die höchste Soll-Temperatur und die dritte die niedrigste Soll-Temperatur aufweist.

Für mehrere Komponenten, die in das Gasgemisch überführt werden sollen, bspw. Wasser und H₂O₂, ist es sinnvoll, dass die Temperatur in der ersten Verdunstungskammer die niedrigste ist, in der zweiten Verdunstungskammer die höchste und in der dritten Verdunstungskammer eine dazwischen, die wie oben ausgeführt der Gleichgewichts-Temperatur des herzustellenden Gasgemisches entspricht.

Mit der Erfindung kommt es beim Strömen des Gases durch die letzte Verdunstungskammer dort nur noch zu sehr geringen Wärmeströmen zwischen Temperiereinheit der Verdunstungskammer und zu verdunstender Flüssigkeit. Das thermodynamische Gleichgewicht stellt sich dann auch schon bei geringen Volumenströmen ein bzw. es besteht keine Abhängigkeit mehr vom Volumenstrom des Gases durch die Verdunstungskammer.

Im Gegenteil, mit der Erfindung besteht dann nur noch die Abhängigkeit (der Genauigkeit der Zusammensetzung des hergestellten Gasgemisches) von der Temperatur und nicht mehr vom Volumenstrom des Trägergases. Das ist sehr vorteilhaft bei den Kalibrierungen mittels des hergestellten Gasgemisches. Es ist somit eine Fehlerquelle ausgeschlossen. Insbesondere, weil meist viele Instrumente kalibriert werden müssen, ist der Ausschluss einer Fehlerquelle sehr wichtig und nützlich.

Denn die Grundidee besteht darin, unterschiedlich temperierte Verdunstungskammern nacheinander zu durchströmen, wobei der Stoffübergang in der zuletzt durchströmten Kammer nahezu verschwindet, so dass sich bis zum Austritt des fertigen Gasgemisches aus der erfindungsgemäßen Vorrichtung das thermodynamische Gleichgewicht auch im kontinuierlichen Gasstrom mit geringer Gasströmungsgeschwindigkeit vollständig einstellen kann. Die zuerst durchströmten Kammern werden dazu meistens bei höheren Temperaturen thermostatiert, als für den Enddampfdruck gemäß thermodynamischem Gleichgewicht notwendig wäre. Dadurch entstehen am Gasübertritt in die zuletzt durchströmte Kammer auch bei unvollständiger Sättigung des Gases in den bereits durchströmten Kammern Dampfdrücke, die sich kaum vom angestrebten Dampfdruck am Austritt aus der Kalibriereinheit unterscheiden.

Die Gleichgewichts-Temperatur im Sinne dieser Anmeldung meint eine innerhalb der letzten der mindestens zwei Verdunstungskammern einzustellende Temperatur, bevorzugt an der Grenzfläche Gas und Flüssigkeit. Diese Temperatur lässt sich aus der gewünschten Genauigkeit der Konzentration des Flüssigkeitsdampfs im Gasgemisch am Auslass des Gasgemisches an der letzten Verdunstungskammer, des Gesamtdrucks des Gasgemisches am Auslass an der letzten Verdunstungskammer, des Partialdrucks des Flüssigkeitsdampfes und der Konzentration der Komponente in der Verdunstungslösung gemäß der in Manatt et al aufgezeigten Berechnungsvorschrift bestimmen. Daraus lässt sich eine zulässige Schwankungsbreite für die einzustellende Gleichgewichts-Temperatur in der letzten Verdunstungskammer ableiten, die durch die Abweichung zwischen IST- und SOLL-Temperatur von maximal ± 10 mK durch das erfindungsgemäße Verfahren vorteilhaft unterschritten wird.

Weiterhin ist der Volumenstrom des Trägergases zu berücksichtigen. Aus der Thermodynamik lässt sich ableiten, dass sich ein idealer Gleichgewichtszustand zwischen einem strömenden Gas und einer ruhenden Flüssigkeit erst nach unendlich langer Kontaktzeit von Gas und Flüssigkeit bei konstanter Temperatur einstellt. Damit sich ein Zustand nahe des idealen Gleichgewichtszustands, bezeichnet im Sinne dieser Anmeldung als Gleichgewichtszustand, nach endlicher Kontaktzeit einstellt und damit technisch nutzbar wird, sind in Ausführungsformen geringfügige Abweichungen vom idealen Gleichgewichtszustand zulässig, bspw. im Bereich von ≤ 0,2% für Kalibrieraufgaben. Diese Abweichung vom idealen Gleichgewichtszustand entspricht in Ausführungsformen der gewünschten Genauigkeit der Konzentration des Flüssigkeitsdampfes im Gasgemisch. Um die Abhängigkeit vom Volumenstrom des Trägergases zu berücksichtigen, ist es vorteilhaft, wenn die kinetischen Eigenschaften der Verdunstungskammer bekannt sind. Diese sind in Ausführungsformen experimentell durch die Aufnahme der prozentualen Sättigung des Flüssigkeitsdampfes im Trägergas in Abhängigkeit der eingestellten Verdunstungstemperatur und des eingestellten Volumenstroms des Trägergases für den Fachmann leicht zu ermitteln und mathematisch darstellbar. Somit ergibt sich bei einer gemäß Schritt a) eingestellten Gleichgewichts-Temperatur in der letzten Verdunstungskammer und einem definierten Volumenstrom des Trägergases am Ausgang der Verdunstungskammer eine prozentuale Sättigung des Flüssigkeitsdampfes und ein Partialdruck des Flüssigkeitsdampfes.

Des Weiteren ist Gegenstand der Erfindung die Verwendung der erfindungsgemäßen Vorrichtung zur Herstellung von Gasgemischen aus Trägergas und Flüssigkeitsdampf, wobei der Flüssigkeitsdampf H₂O₂ und Wasser umfasst, insbesondere im erfindungsgemäßen Verfahren.

Schließlich ist auch Gegenstand der Erfindung die Verwendung der erfindungsgemäßen Vorrichtung zur dezentralen Herstellung definierter Gasgemische aus einem Trägergas und Flüssigkeitsdampf, wobei der Flüssigkeitsdampf H₂O₂ und Wasser umfasst, für chemische Prozesse, für die Kalibrierung von Gassensoren, in der Medizin, in der pharmazeutischen Industrie, in der Umweltanalytik und in der Beschichtungstechnik.

Vorteilhaft ist mit der Erfindung die hochpräzise Herstellung eines Gasgemisches möglich. Sie erlaubt die Einstellung präziser Konzentrationen dieser verdunsteten oder verdampften Substanzen im unteren ppmv-Bereich. Die Einheit ppmv beschreibt ein Volumenverhältnis, d.h. 1ppmv entspricht 1E⁻⁶ / 1, d.h. 0,0001 Vol.-%.

Damit erlaubt sie eine zuverlässige Kalibrierung von bspw. Gassensoren, auch im Bereich geringer Dampfkonzentrationen.

Dem zu Grunde liegt auch der Vorteil, dass temperatursensitive Substanzen als die "zu verdunstende Flüssigkeit" nicht zersetzt werden. Denn es wird mit der Erfindung erreicht, dass vergleichsweise sehr wenig Energie pro Flächeneinheit der ausgedehnten Phasengrenze flüssig/gasförmig während der Verdunstung übertragen wird. Denn es wird mit der Erfindung wenig Energie auf die gesamte Länge der Verdunstungskammern verteilt.

Darüber hinaus werden die hergestellten Gasgemische in ihrer Zusammensetzung nicht durch Schwankungen des Trägergas-Volumenstroms beeinträchtigt. Denn die Erfindung ermöglicht die Einstellung konstanter Dampfpartialdrücke unabhängig von der Geschwindigkeit oder dem Volumenstrom des Trägergas-Stromes.

Das bereitgestellte, bspw. zur Kalibrierung nutzbare Gasgemisch kann dezentral, d.h. anwendungsort-nah bereitgestellt werden.

Die Herstellung ist membranfrei möglich, d.h. am Ort der Verdunstung kann auf Membranen verzichtet werden. Die Erfindung ist damit störunanfälliger.

Vorteil ist auch, dass die Erfindung von der Sättigung des zu Beginn eingesetzten Trägergases mit der zu verdunstenden Flüssigkeit, d.h. dem Flüssigkeitsdampf, unabhängig ist. Diese hat keinen Einfluss auf die präzise herstellbaren Gasgemische.

Darüber hinaus ermöglicht die Erfindung auch die hochpräzise Untersuchung der Thermodynamik von Mischphasen.

Sogar im Bereich extrem niedriger Trägergas-Volumenströme von unter 1 SLM (= unter 1 l/min unter Normbedingungen) können bei niedrigen Prozesstemperaturen von unter 30 °C mit hoher Präzision sehr geringe Dampfkonzentrationen von unter 100 ppmv eingestellt werden.

Die Erfindung ist für eine Vielzahl von Substanzen anwendbar.

Temperaturempfindliche Substanzen werden durch die Erfindung nicht aufgrund hoher Prozesstemperaturen zersetzt.

Das Verfahren läuft zuverlässig ab und der apparative Aufwand ist gering. Beispielsweise erlaubt die Erfindung eine membranfreie Arbeitsweise.

Bisher war es nicht möglich, Kalibrierungsgase präzise auf so kleinem Raum herzustellen. Denn die Erfindung erlaubt eine kleine Länge von beispielsweise 180 mm pro Verdunstungskammer, so dass dies bei mindestens 2 Verdunstungskammern und S-förmiger Anordnung zu einer nicht wesentlich längeren Apparatur führt, was extrem klein und platzsparend ist.

Die Erfindung eignet sich ganz besonders gut zur Herstellung eines Gasgemisches aus Trägergas mit H₂O₂ und Wasser.

In einer bevorzugten Ausführungsform der Erfindung sind mindestens drei Verdunstungskammern in der erfindungsgemäßen Vorrichtung bzw. dem Verfahren vorgesehen, insbesondere auch genau drei. Dies ist besonders günstig, wenn der Flüssigkeitsdampf aus zwei Komponenten aufgebaut sein soll.

In einer ebenfalls bevorzugten Ausführungsform des Verfahrens ist der Temperaturunterschied in Schritt b) maximal 3 K.

In einer bevorzugten Ausführungsform des Verfahrens ist im hergestellten Gasgemisch die Volumenkonzentration des Flüssigkeitsdampfes (der zu verdunstenden Flüssigkeit) < 100 ppmv.

In einer bevorzugten Ausführungsform wird die zu verdunstende Flüssigkeit in den Verdunstungskammern während des kontinuierlichen Schrittes c) des Verfahrens nicht bewegt und auch nicht gepumpt.

Die Verdunstungskammern sind erfindungsgemäß in horizontaler Aufstellrichtung (der Vorrichtung) segmentiert, indem jede Verdunstungskammer mindestens eine vertikale Wand mit einer Öffnung aufweist, besonders bevorzugt mindestens zwei solcher Wände, insbesondere auch genau zwei. Auch mehrere Öffnungen der Wand sind möglich. Horizontale Aufstellrichtung und vertikale Wand stehen zur Verdeutlichung jedenfalls im Wesentlichen senkrecht zueinander, wobei auch eine Abschrägung der Wände möglich ist, im Bereich ±20°. Das heißt, das Gas (Trägergas in der ersten Verdunstungskammer bzw. zwischenzeitlich erhaltenen Gasmischungen in den danach folgenden Verdunstungskammern) kann die jeweilige Verdunstungskammer in Längsrichtung (das ist in Aufstellrichtung der erfindungsgemäßen Vorrichtung: horizontal) durch die Öffnung durchströmen. Vorteil dieser Ausgestaltung mit Wand mit Öffnung ist es, dass verhindert wird, dass die in der Verdunstungskammer einzubringende, zu verdampfende Flüssigkeit durch den Trägergasstrom in oberflächliche Schwingung versetzt oder dass Aufwirbelungen erzeugt werden. Der Übertritt der zu verdunstenden Flüssigkeit in die Gasphase ist damit über nahezu unbewegte Flüssig-Gas-Grenzflächen aerosolfrei möglich.

Vorteilhaft wird damit auch vermieden, dass sich die Stoffkonzentration innerhalb einer Verdunstungskammer ändert, was sich bei Lösungen ergibt, deren Dampfdrücke sich nicht nach dem Raoultschen Gesetz einstellen und somit zu signifikanten Konzentrationsänderungen während der Verdunstung führt.

Die Öffnungen sind geeigneter Weise in einer Höhe in der oberen Hälfte der Wände angebracht, insbesondere im oberen Drittel, so dass der Flüssigkeitsstand unterhalb der Öffnungen liegt.

Die horizontale Aufstellrichtung ist entlang der Länge einer Verdunstungskammer ausgerichtet. Damit ist die Verdunstungskammer entlang der Gasflussrichtung des Trägergases vom Einlass zum Auslass durch die Verdunstungskammer segmentiert. Die Länge der Verdunstungskammer meint dabei die Ausdehnung einer Verdunstungskammer entlang der Gasflussrichtung des Trägergases durch die Verdunstungskammer.

In einer bevorzugten Ausführungsform der Erfindung haben die Verdunstungskammern eine Länge von maximal 500 mm, insbesondere max. 250 mm, oder auch max. 200 mm, besonders bevorzugt von 160 mm - 200 mm, auch max. 180 mm. Vorteilhaft ist in dieser Ausführung die Fehleranfälligkeit der Vorrichtung am geringsten und der Platzbedarf für eine dezentrale Unterbringung am jeweiligen Verwendungsort gering.

In einer ebenfalls bevorzugten Ausführung der Erfindung ist das Innenwandmaterial der Verdunstungskammern ausgewählt aus Glas, Polytetrafluorethylen, Edelstahl und Keramik. Vorteilhaft kommt es so zu keiner methodenlimitierenden Adsorption bzw. Reaktion zwischen Bestandteilen der zu verdunstenden Lösung und der Innenwand der Verdunstungskammern.

Bevorzugt umfasst die erfindungsgemäße Vorrichtung auch
- einen Drucksensor für die Messung des Umgebungsdrucks und/oder des Drucks des Trägergases bei Eintritt in die Vorrichtung, insbesondere bei Eintritt in die erste Verdunstungskammer, und
- einen Druckregler zum Ausgleich des sich verändernden Umgebungsdruckes und/oder dieses Drucks des Trägergases.

Sie sind also für die Messung und den Ausgleich von Schwankungen im Umgebungsdruck und/oder beim Trägergas-Druck vorgesehen.

"Umgebungsdruck" ist dabei der Druck in dem benachbarten System, in dem das mit der Erfindung bereitgestellte Gasgemisch Verwendung finden soll, bspw. der Druck in einer zu kalibrierenden Anlage. Der Druckregler ist demnach sinnvoller Weise so angeordnet, dass er in der Lage ist, den Umgebungsdruck in dem benachbart angeordneten System zu regulieren. Der Drucksensor bestimmt diesen Druck, so dass damit Schwankungen erfasst werden, die der Druckregler ausgleichen soll. Sinnvollerweise ist dafür besonders bevorzugt auch eine elektronische Steuereinheit vorhanden.

Vorteil dieser Ausführungsformen mit Drucksensor und Druckregler ist, dass minimale Druckschwankungen bei der Abnahme des hergestellten Gasgemisches (bspw. für die Kalibrierung eines benachbarten Systems) oder bei der Trägergasversorgung die hochpräzise eingestellte Zusammensetzung des Gasgemisches nicht mehr beeinflussen.

Bevorzugt umfasst die erfindungsgemäße Vorrichtung einen coulometrischen Festelektrolyt-Gassensor zur Überwachung des störungsfreien Betriebes. Dieser ist sinnvollerweise am Ausgang der letzten Verdunstungskammer angebracht, wo das hergestellte Gasgemisch bereitgestellt wird. Vorteilhaft bleibt in dieser Ausführungsform eine auftretende Betriebsstörung nicht unentdeckt und es wird verhindert, dass durch eine sich verfälschende Konzentration im hergestellten Gasgemisch auch weitere Messungen benachbarter Systeme betroffen sind.

Ganz besonders bevorzugt umfasst dieser coulometrische Festelektrolyt-Detektor ein oxidionenleitendes Material wie bspw. Yttriumoxid stabilisiertes Zirconiumdioxid.

In einer bevorzugten Ausführungsform des erfindungsgemäßen Verfahrens liegt der Temperaturunterschied in Schritt b) bei 0,01-4,5 K, insbesondere bei maximal 4K, besonders bevorzugt 0,5-3,5 K, insbesondere auch 0,1-3 K oder auch 0,5-1,5 K. Bevorzugt sind damit auch Trägergas-Ströme von > 100 ml/min möglich, bis zu ≤ 2 I/min (SLM, bei Normbedingungen). Denn bei einem Temperaturunterschied von 0 K muss der Trägergas-Strom sonst bei maximal 100 ml/min liegen.

In einer bevorzugten Ausführungsform der Erfindung mit drei Verdunstungskammern ist der Temperaturunterschied zwischen erster und zweiter Verdunstungskammer und zwischen zweiter und dritter Verdunstungskammer unterschiedlich (Unterschied von mindestens 2 K). Insbesondere ist er 3 K±0,3 K zwischen erster und zweiter und 0,5-1 K zwischen zweiter und dritter Verdunstungskammer. In Folge ergibt sich ein Temperaturunterschied zwischen erster und dritter Kammer im Bereich von 1,7-2,8 K. In einer ebenfalls bevorzugten Ausführungsform des Verfahrens liegt die in Schritt a) eingestellte Gleichgewichts-Temperatur bei maximal 50°C, besonders bevorzugt bei max. 30°C.

In einer weiteren bevorzugten Ausführungsform des Verfahrens liegt die Strömungsgeschwindigkeit (des Trägergases) zwischen 0 und 2 l/min bei Normbedingungen, besonders bevorzugt bei < 1 l/min bei Normbedingungen.

Der Volumenstrom (des Trägergases) liegt erfindungsgemäß zwischen 0 und 2 I/min bei Normbedingungen, besonders bevorzugt bei < 1 l/min bei Normbedingungen.

Besonders bevorzugt werden diese beiden Ausführungsformen bzgl. Temperatur und Strömungsgeschwindigkeit kombiniert. Besonders bevorzugt werden diese beiden Ausführungsformen bzgl. Temperatur und Volumenstrom kombiniert.

Der Flüssigkeitsdampf im herzustellenden Gasgemisch umfasst H₂O₂ und Wasser, und in der ersten Verdunstungskammer befindet sich Wasser und in den folgenden Verdunstungskammern befindet sich eine Wasser-H₂O₂-Mischung. In dieser Ausführungsform sind erfindungsgemäß genau drei Verdunstungskammern von der Vorrichtung umfasst. Vorteilhaft kann dadurch im Trägergas bei der Passage der ersten Verdunstungskammer zunächst ein definierter Wasserdampfpartialdruck eingestellt werden, mit dem die ansonsten ungleichen Verdunstungsraten von H₂O und H₂O₂ in den nachfolgenden Verdunstungskammern (zweite und dritte) weitgehend ausgeglichen werden und so über lange Dosierzeiträume auch bei hohen Trägergasströmen gleichmäßige Dampfkonzentrationen am Ausgang der Vorrichtung erreicht werden.

In dieser Ausführungsform werden erfindungsgemäß in Schritt b) die Temperaturunterschiede wie folgt eingestellt: Die Temperatur in der ersten Verdunstungskammer ist die niedrigste, in der zweiten Verdunstungskammer die höchste und in der dritten Verdunstungskammer eine dazwischenliegende, die wie oben ausgeführt der Gleichgewichts-Temperatur des herzustellenden Gasgemisches entspricht. In einer expliziten Variante davon beträgt der Unterschied zwischen erster und zweiter Verdunstungskammer dabei 3 K±0,3 K und zwischen zweiter und dritter Verdunstungskammer zwischen 0,5-1 K. In Folge ergibt sich ein Temperaturunterschied zwischen erster und dritter Kammer im Bereich von 1,7-2,8 K. Vorteilhaft wird dabei ausgeglichen, dass die Verdunstungsraten von Wasser und H₂O₂ unterschiedlich sind.

In einer ganz anderen Ausführungsform der Erfindung befindet sich in allen Verdunstungskammern die gleiche zu verdunstende Flüssigkeit.

Besonders bevorzugt wird damit nur eine einzelne Komponente in das Gasgemisch überführt. Die Vorrichtung hat dabei insbesondere genau drei Verdunstungskammern und im Verfahren werden im Schritt b) Temperaturunterschiede von max. 5 K zwischen erster und zweiter und zwischen zweiter und dritter Verdunstungskammer eingestellt, wobei die erste die höchste Soll-Temperatur und die dritte die niedrigste Soll-Temperatur aufweist. Erfindungsgemäß entspricht die Temperatur in der letzten, hier dritten, Kammer der Gleichgewichts-Temperatur des herzustellenden Gasgemisches.

In einer bevorzugten Ausführung ist die Strömungsgeschwindigkeit des Trägergases in die erste Verdunstungskammer und danach durch alle folgenden Verdunstungskammern gleich und ist mit einem Masseflussregler einstellbar. In einer weiteren bevorzugten Ausführungsform ist der Volumenstrom des Trägergases in die erste Verdunstungskammer und danach durch alle folgenden Verdunstungskammern gleich und ist mit einem Masseflussregler einstellbar.

In einer ebenfalls bevorzugten Ausführungsform der Erfindung ist in der Temperiereinheit ein Rührwerk vorgesehen, welches mit Hilfe magnetischer Kupplung durch das Gehäuse der Temperiereinheit berührungslos angetrieben wird.

Eine andere bevorzugte Ausführungsform sieht als Kühl- bzw. Heizelemente (Thermostate) innerhalb der Temperiereinheit Peltierelemente und als Temperatursensor einen Standard-Platin-Widerstands-Temperatursensor vor.

Bevorzugt wird das erfindungsgemäße Verfahren kontinuierlich betrieben.

In einer bevorzugten Ausführungsform der Vorrichtung hat diese keine Verbindungen zwischen den Verdunstungskammern für die zu verdunstende Flüssigkeit (d.h. solche, die in der unteren Hälfte der Verdunstungskammern angeordnet wären und die Verdunstungskammern so miteinander verbinden. Möglich sind in dieser bevorzugten Ausführung allerdings Leitungen zum einzelnen befüllen jeder Verdunstungskammer. Denn die Vorrichtung ist für ruhende "zu verdunstende Flüssigkeiten" vorgesehen.

In einer ebenfalls bevorzugten Ausführungsform weist die Vorrichtung kein Bauteil zur Erzeugung von Blasen in einer Flüssigkeit (wie bspw. einer Blasenfritte) auf. Das Verfahren verzichtet dementsprechend auf das Einleiten eines Gases in eine Flüssigkeit.

In einer bevorzugten Ausführungsform ist mindestens eine der Verdunstungskammern eine quer liegend zu nutzende Röhre, d.h. sie weist ein Verhältnis von Höhe:Länge von 1:mind.1,5, besser 1 zu mind. 2 auf. Ganz besonders bevorzugt sind alle der vorgesehenen Verdunstungskammern solche quer liegenden Röhren.

Für die Realisierung der Erfindung ist es auch zweckmäßig, die vorbeschriebenen erfindungsgemäßen Ausgestaltungen, Ausführungsformen und Merkmale der Ansprüche miteinander zu kombinieren.

Anhand von Zeichnungen wird die Erfindung näher erläutert.

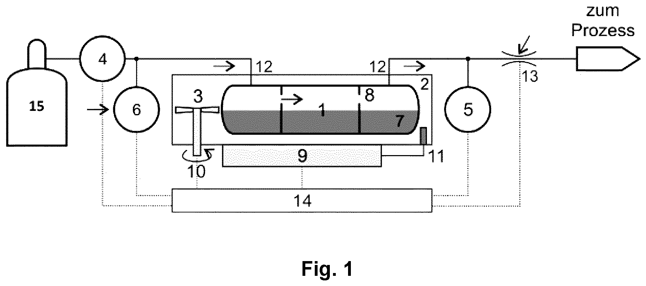

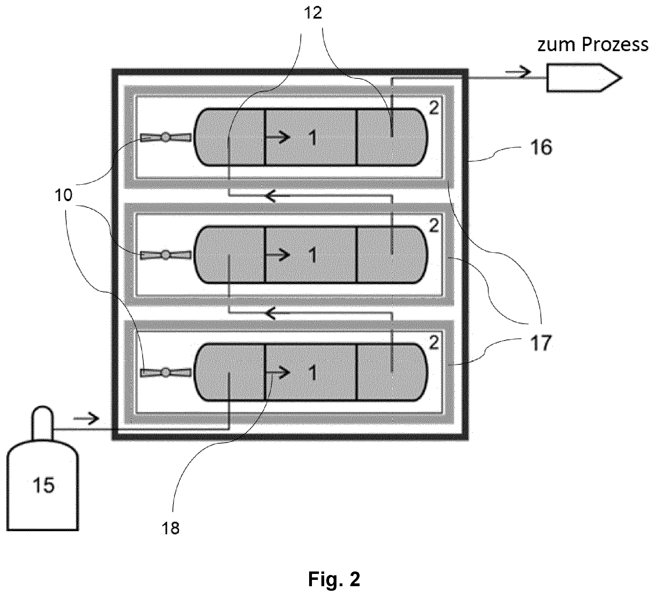

Fig. 1 zeigt eine vereinfachte, schematische Darstellung mit nur einer Verdunstungskammer, die als Ausführungsbeispiel mit drei Verdunstungskammern in Ausführungsbeispiel 1 beschrieben wird. Fig. 2 zeigt ergänzend eine Ausführungsform der erfindungsgemäßen Vorrichtung mit drei nebeneinander angeordneten Verdunstungskammern.

Nachfolgend soll die Erfindung anhand von Ausführungsbeispielen eingehender erläutert werden. Die Ausführungsbeispiele sollen dabei die Erfindung beschreiben ohne diese zu beschränken.

### Ausführungsbeispiele

### Ausführungsbeispiel 1:

Das Ausführungsbeispiel wird schematisch durch Fig. 1 dargestellt, wobei in Ausführungsbeispiel 1 jedoch genau drei Verdunstungskammern 1 mit jeweils einer separaten Temperiereinheit 2, umfassend Thermostat 9 und Temperatursensor 11, vorgesehen sind.

Erkennbar ist auch die Segmentierung innerhalb der einen gezeigten Verdunstungskammer 1 (wobei alle drei Verdunstungskammern diese Segmentierung aufweisen) mittels zweier vertikaler Wände 8. Sie weisen jeweils eine Öffnung für das Hindurchströmen des Gases auf, die oberhalb des Flüssigkeitsstandes der zu verdunstenden Flüssigkeit 7 angeordnet ist.

Die Verdunstungskammern 1 sind als liegende segmentierte Röhren ausgestaltet, die im unteren Bereich die zu verdunstende Flüssigkeit 7 enthalten und im oberen Bereich den Ein- und Auslass 12 für das Trägergas bzw. für die zwischen den Verdunstungskammern zu transportierenden Gase aufweisen. Das Trägergas strömt nach Eintritt in die Verdunstungskammer 1 über die Flüssigkeitsoberfläche und nimmt dabei den verdunstenden Dampf auf. Das Ausführungsbeispiel der Erfindung zur definierten Verdunstung von Wasser/Wasserstoffperoxid-Gemischen (H₂O/H₂O₂) enthält also drei unterschiedlich temperierte Verdunstungskammern S1/1, S1/2 und S1/3, in denen sich in der durchströmten Reihenfolge Wasser (S1/1) und H₂O₂/H₂O-Lösung (S1/2 und S1/3) befinden. Dadurch kann im Trägergas bei der Passage von (S1/1) zunächst ein definierter Wasserdampfpartialdruck eingestellt werden, mit dem die ansonsten ungleichen Verdunstungsraten von H₂O und H₂O₂ in den Strömungszellen S1/2 und S1/3 weitgehend angeglichen werden und so über lange Dosierzeiträume auch bei hohen Trägergasströmen gleichmäßige Dampfkonzentrationen am Ausgang der Vorrichtung erreicht werden. Die Verdunstungskammer S1/2 ist dabei volumenstromabhängig geringfügig höher temperiert, als die Verdunstungskammer S1/3, deren Temperatur mit der absoluten Genauigkeit von 10 mK auf den Wert eingestellt wird, die gemäß der Dampfdruckkurve von H₂O₂/H₂O Gemischen zu den gewünschten Dampfdrücken dieser Komponenten am Ausgang der Vorrichtung führt. Am Ausgang der Verdunstungskammer S1/2 stellen sich dann anhand der kinetischen Randbedingungen in dieser Verdunstungskammer bereits Dampfdrücke beider Komponenten ein, die weniger als 2 % von den am Ausgang der Verdunstungskammer S1/3, d.h. endgültig angestrebten Dampfdrücken abweichen. Damit ist gewährleistet, dass sich in der Verdunstungskammer S1/3 nur vernachlässigbar geringe Wärmeströme einstellen und sich dort das thermodynamische Gleichgewicht im Rahmen der angestrebten Dosiergenauigkeit auch beim größten einstellbaren Volumenstrom des Trägergases einstellt. An der Vorrichtung ist ein hochpräziser (Absolut-)Drucksensor 6 angeordnet, mit dem während der Dampfdosierung wahlweise der umgebende Luftdruck bzw. der Druck des Trägergases am Eingang der Verdunstungseinheit mit einer Genauigkeit < ± 0,3 mbar kontinuierlich aufgezeichnet werden. Da die Dampfkonzentration am Ausgang der Vorrichtung sich aus dem Verhältnis des sich bei der eingestellten Verdunstungstemperatur in der Verdunstungskammer 1 thermodynamisch ergebenden Dampfdruckes zum herrschenden Umgebungsdruck am Ausgang der letzten Verdunstungskammer ergibt, ist für die hochpräzise Bestimmung der Dampfkonzentration die Kenntnis des Umgebungsdruckes unerlässlich.

Fig. 2 zeigt ergänzend eine Ausführungsform einer Vorrichtung Herstellung von Gasgemischen aus einem Trägergas und Flüssigkeitsdampf in der Draufsicht. Die Vorrichtung weist drei Verdunstungskammern (1) auf, die jeweils einzeln temperaturregelbar und gemäß Fig. 1 ausgestaltet sind. Die drei Verdunstungskammern (1) sind parallel zueinander entlang ihrer horizontalen Aufstellrichtung bzw. ihrer Länge nebeneinander angeordnet. Weiterhin erkennbar ist ein Gehäuse (16), in dem die drei Verdunstungskammern (1) in ihrer jeweiligen Temperiereinheit (2) angeordnet sind. Die drei Verdunstungskammern (1) sind thermisch voneinander entkoppelt durch eine Wärmedämmung (17), die jeweils die einzelnen Temperiereinheiten (2) umgibt und als Elastomerschaum (17) ausgebildet ist. Der Pfeil (18) kennzeichnet die Gasflussrichtung bzw. Trägergasflussrichtung in jeder der Verdunstungskammern (1) entlang der Länge der jeweiligen Verdunstungskammer (1).

### Ausführungsbeispiel 2:

Um in einem weiteren Ausführungsbeispiel die Dampfkonzentration auch bei schwankenden Umgebungsdrücken hochpräzise auf einen bestimmten Wert einstellen zu können, bieten sich zwei Lösungsansätze an:
In einem ersten Lösungsansatz werden die Temperaturen der Strömungszellen in Abhängigkeit vom Gesamtdruck in Echtzeit so angepasst, dass sich immer die Konzentration präzise einstellt. Im Fall eines ansteigenden Umgebungsdrucks müssten so die Verdunstungstemperaturen geringfügig erhöht werden, während im Fall sinkender Umgebungsdrücke die Verdunstungstemperaturen geringfügig abgesenkt werden. Dieser Ansatz ist nur dann umsetzbar, wenn sich der temporale Gradient des Umgebungsdrucks immer unterhalb der möglichen Änderungsgeschwindigkeit der Temperatur in den Strömungszellen entsprechend der Dampfdruckkurve einstellt.

Ist dies nicht gegeben, kann in einem zweiten Lösungsansatz am Ausgang der letzten Verdunstungskammer ein Druckregler 13 installiert werden, mit dem der dortige Absolutdruck konstant gehalten wird. Diese Aufgabe kann mit hochpräzisen Drucksensoren so erfüllt werden, dass die Schwankungen dieses Drucks unter 0,01 mbar gehalten werden.

Zur Dokumentation des störungsfreien Betriebs der Verdunstungseinheit kann am Ausgang der Verdunstungseinheit ein kalibrierter Gassensor 5 angebracht sein. Im Fall von Dämpfen, die sich in einer definierten Reaktion mit Sauerstoff umsetzen lassen (z.B. Ethanol oder Aceton) oder von Dämpfen, die bei hoher Temperatur oder an einem Katalysator Sauerstoff definiert freisetzen (z.B. H₂O₂) kann diese Konzentration mit einem coulometrischen Festelektrolytsensor rückführbar gemessen werden. Die gesamte erfindungsgemäße Vorrichtung wird durch eine elektronische Steuereinheit (Mess- und Regeleinheit) 14 über die in Fig. 1 gestrichelt dargestellten Verbindungen ausgewertet und geregelt. Diese Einheit 14 dient zudem der Aufbereitung, Visualisierung und Speicherung der Messdaten.

### Zitierte Nichtpatentliteratur:

Findley, M. E.
Vaporization through Porous Membranes.
Ind. Eng. Chem. Process Des. Dev., 1967, 6, 2, 226-230.
Webb, B. C.
A Validated Calibration Method for Hydrogen Peroxide Vapour Sensors,
Research Article in PDA journal of pharmaceutical science and technology / PDA.49-54, 2001, Vol. 55, No. 1.
Klemm, E.; Mathivanan, G.; Schwarz, T.; Schirrmeister, S.
Evaporation of hydrogen peroxide with a microstructured falling film,
Chemical Engineering and Processing, 2011, 50, 1010-1016.
S.L. Manatt, M.R.R. Manatt: On the Analyses of Mixture Vapor Pressure Data: The Hydrogen Peroxide/Water System and Its Excess Thermodynamic Functions. Chem. Eur. J. 2004, 10, 6540 - 6557, DOI: 10.1002/chem.200400104.

### Bezugszeichen

- 1: Eine von mindestens zwei Verdunstungskammern
- 2: Temperiereinheit (gehörig zur jeweiligen Verdunstungskammer)
- 3: Wärmeträger
- 4: Masseflussregler (für Trägergas-Strom)
- 5: Gassensor (zur Überwachung des störungsfreien Betriebes)
- 6: Drucksensor
- 7: Zu verdunstende Flüssigkeit
- 8: Vertikale Wand
- 9: Thermostat (zur Kühlung bzw. Heizung der jeweiligen Verdunstungskammer)
- 10: Rührwerk (zur Umwälzung des Wärmeträgers)
- 11: Temperatursensor
- 12: Ein- und Auslass jeder Verdunstungskammer
- 13: Druckregler
- 14: Elektronische Steuereinheit
- 15: Trägergasversorgung
- 16: Gehäuse
- 17: Wärmedämmung
- 18: Gasflussrichtung bzw. Trägergas-Flussrichtung

## Patentansprüche

1. Vorrichtung zur Herstellung von Gasgemischen aus einem Trägergas und Flüssigkeitsdampf, wobei der Flüssigkeitsdampf H₂O₂ und Wasser umfasst, umfassend
• mindestens zwei benachbarte Verdunstungskammern (1) ausgebildet zur Aufnahme einer zu verdunstenden Flüssigkeit (7), ausgewählt aus Wasser und einer wässrigen Wasserstoffperoxid-Lösung mit einer Konzentration im Bereich von 0,1 g / I bis 500 g / I, wovon jede einzeln temperaturregelbar ist,
und die mindestens zwei Verdunstungskammern (1) durch eine Wärmedämmung (17), die die Temperiereinheit (2) der jeweiligen Verdunstungskammer (1) umgibt, thermisch voneinander entkoppelt sind, und
die Verdunstungskammern (1) jeweils in horizontaler Aufstellrichtung segmentiert sind, indem jede Verdunstungskammer (1) mindestens eine vertikale Wand (8) mit einer Öffnung aufweist;
• jeweils eine Temperiereinheit (2) an jeder der Verdunstungskammern (1), wobei die Temperiereinheit (2) als Thermostatbad ausgebildet ist und eine Wanne und einen die Wanne verschließenden, temperierbaren Deckel umfasst, und
• Gasleitungen, welche eine Trägergasversorgung (15) mit der ersten Verdunstungskammer (1) verbinden, und welche die anderen Verdunstungskammern (1) nacheinander miteinander verbinden und welche an der letzten Verdunstungskammer (1) einen Auslass (12) bereitstellen, so dass bei Benutzung das Trägergas durch die erste und von dort nacheinander durch die weiteren Verdunstungskammern (1), entlang der Oberfläche einer in den Verdunstungskammern (1) befindlichen, zu verdunstenden Flüssigkeit (7) geleitet wird.

2. Vorrichtung nach Anspruch 1, wobei mindestens drei Verdunstungskammern (1) umfasst sind.

3. Vorrichtung nach einem der Ansprüche 1 oder 2, wobei die Verdunstungskammern (1) eine Länge von maximal 200 mm aufweisen.

4. Vorrichtung nach einem der Ansprüche 1 bis 3, wobei das Innenwandmaterial der Verdunstungskammern (1) ausgewählt ist aus Glas, Polytetrafluorethylen, Edelstahl und Keramik.

5. Vorrichtung nach einem der Ansprüche 1 bis 4, umfassend
• einen Drucksensor (6) für die Messung des Umgebungsdrucks und/oder des Drucks des Trägergases bei Eintritt in die Vorrichtung, und
• einen Druckregler (13) zum Ausgleich des sich verändernden Umgebungsdruckes und/oder dieses Trägergas-Druckes.

6. Vorrichtung nach einem der Ansprüche 1 bis 5, umfassend einen coulometrischen Festelektrolyt-Gassensor (5) zur Überwachung des störungsfreien Betriebes.

7. Verfahren zur Herstellung von Gasgemischen aus einem Trägergas und Flüssigkeitsdampf, wobei der Flüssigkeitsdampf H₂O₂ und Wasser umfasst, mit den Schritten:
a) Einstellung der Gleichgewichts-Temperatur des herzustellenden Gasgemisches als Sollwert in einer letzten von mindestens zwei einzeln temperaturregelbaren und durch eine Wärmedämmung (17), die die Temperiereinheiten (2) der jeweiligen Verdunstungskammer (1) umgibt, thermisch voneinander entkoppelten Verdunstungskammern (1), wobei die Verdunstungskammern (1) in horizontaler Aufstellrichtung segmentiert sind, indem jede mindestens eine vertikale Wand (8) mit einer Öffnung aufweist, und
wobei die Temperiereinheiten (2) als Thermostatbad ausgebildet sind und eine Wanne und einen die Wanne verschließenden, temperierbaren Deckel umfassen,
b) Einstellung eines Temperaturunterschieds von maximal 5 K zwischen jeweils benachbarten Verdunstungskammern (1), wobei die Temperatur in der ersten Verdunstungskammer (1) die niedrigste, in der zweiten Verdunstungskammer (1) die höchste und in der dritten Verdunstungskammer (1) eine dazwischenliegende ist und der Gleichgewichtstemperatur des herzustellenden Gasgemisches entspricht, und
c) Leiten eines Trägergases mit einem Volumenstrom zwischen 0 und 2 L/min bei Standardbedingungen durch die erste und von dort nacheinander durch die weiteren Verdunstungskammern (1), entlang der Oberfläche einer in den Verdunstungskammern befindlichen, zu verdunstenden Flüssigkeit (7),
wobei die zu verdunstende Flüssigkeit (7) ausgewählt ist aus Wasser und einer wässrigen Wasserstoffperoxid-Lösung mit einer Konzentration im Bereich von 0,1 g / I bis 500 g / I, und
wobei sich in der ersten Verdunstungskammer (1) Wasser als zu verdunstende Flüssigkeit und in den weiteren Verdunstungskammern (1) eine Wasser-H₂O₂-Mischung befindet.

8. Verfahren nach Anspruch 7, wobei der Temperaturunterschied in Schritt b) bei 0,01-4,5 K liegt.

9. Verfahren nach einem der Ansprüche 7 oder 8, wobei die in Schritt a) eingestellte Gleichgewichts-Temperatur bei maximal 30°C und der Volumenstrom des Trägergases in Schritt c) bei < 1 L/min bei Standardbedingungen liegt.

10. Verwendung der Vorrichtung nach einem der Ansprüche 1 bis 6 zur Herstellung von Gasgemischen aus einem Trägergas und Flüssigkeitsdampf, wobei der Flüssigkeitsdampf H₂O₂ und Wasser umfasst.

11. Verwendung der Vorrichtung nach einem der Ansprüche 1 bis 6 zur dezentralen Herstellung definierter Gasgemische aus einem Trägergas und Flüssigkeitsdampf, wobei der Flüssigkeitsdampf H₂O₂ und Wasser umfasst, für chemische Prozesse, für die Kalibrierung von Gassensoren, in der Medizin, in der pharmazeutischen Industrie, in der Umweltanalytik und der Beschichtungstechnik.

## Claims

1. Device for producing gas mixtures from a carrier gas and liquid vapor, wherein the liquid vapor comprises H2O2 and water, comprising
• at least two adjacent evaporation chambers (1) designed to receive a liquid (7) to be evaporated, selected from water and an aqueous hydrogen peroxide solution with a concentration in the range of 0.1 g/l to 500 g/l, each of which is individually temperature-controllable,
and the at least two evaporation chambers (1) are thermally decoupled from one another by a thermal insulation (17) which surrounds the temperature-control unit (2) of the respective evaporation chamber (1), and
the evaporation chambers (1) are each segmented in the horizontal direction of installation, in that each evaporation chamber (1) has at least one vertical wall (8) with an opening;
• one temperature-control unit (2) on each of the evaporation chambers (1), wherein the temperature-control unit (2) is designed as a thermostatic bath and comprises a tray and a temperature-controllable cover closing the tray, and
• gas lines which connect a carrier gas supply (15) to the first evaporation chamber (1), and which connect the other evaporation chambers (1) to each other in succession and provide an outlet (12) at the last evaporation chamber (1), so that during use the carrier gas is conducted through the first and from there in succession through the further evaporation chambers (1) along the surface of a liquid (7) to be evaporated which is located in the evaporation chambers (1).

2. Device according to claim 1, wherein at least three evaporation chambers (1) are comprised.

3. Device according to one of claims 1 or 2, wherein the evaporation chambers (1) have a maximum length of 200 mm.

4. Device according to one of claims 1 to 3, wherein the inner wall material of the evaporation chambers (1) is selected from glass, polytetrafluoroethylene, stainless steel, and ceramic.

5. Device according to one of claims 1 to 4, comprising
• a pressure sensor (6) for measuring the ambient pressure and/or the pressure of the carrier gas upon entry into the device, and
• a pressure regulator (13) for compensating for the changing ambient pressure and/or this carrier gas pressure.

6. Device according to one of claims 1 to 5, comprising a coulometric solid electrolyte gas sensor (51) for monitoring trouble-free operation.

7. Method for producing gas mixtures from a carrier gas and liquid vapor, wherein the liquid vapor comprises H2O2 and water, comprising the steps of:
a) setting the equilibrium temperature of the gas mixture to be produced as a setpoint value in a last of at least two individually temperature-controllable evaporation chambers (1) which are thermally decoupled from one another by a thermal insulation (17) surrounding the temperature-control units (2) of the respective evaporation chamber (1), wherein the evaporation chambers (1) are segmented in the horizontal direction of installation in that each have at least one vertical wall (8) with an opening, and
b) setting a temperature difference of no more than 5 K between mutually adjacent evaporation chambers (1), wherein the temperature in the first evaporation chamber (1) is the lowest, in the second evaporation chamber (1) the highest, and in the third evaporation chamber (1) in between, and corresponds to the equilibrium temperature of the gas mixture to be produced, and
c) conducting a carrier gas with a volume flow between 0 and 2 L/min at standard conditions through the first and from there successively through the other evaporation chambers (1) along the surface of a liquid (7) to be evaporated located in the evaporation chambers,
wherein the liquid (7) to be evaporated is selected from water and an aqueous hydrogen peroxide solution with a concentration in the range of 0.1 g/l to 500 g/l, and
wherein, in the first evaporation chamber (1), water is disposed as the liquid to be evaporated and, in the further evaporation chambers (1), a water-H2O2 mixture is disposed.

8. Method according to claim 7, wherein the temperature difference in step b) is at 0.01-4.5 K.

9. Method according to one of claims 7 or 8, wherein the equilibrium temperature set in step a) is at a maximum of 30°C and the volume flow of the carrier gas in step c) is <1 L/min under standard conditions.

10. Use of the device according to one of claims 1 to 6 for the production of gas mixtures from a carrier gas and liquid vapor, wherein the liquid vapor comprises H2O2 and water.

11. Use of the device according to one of claims 1 to 6 for the decentralized production of defined gas mixtures from a carrier gas and liquid vapor, wherein the liquid vapor comprises H2O2 and water, for chemical processes, for the calibration of gas sensors, in medicine, in the pharmaceutical industry, in environmental analysis, and in coating technology.

## Revendications

1. Dispositif pour la production de mélanges gazeux composés d'un gaz porteur et d'une vapeur de liquide, laquelle vapeur de liquide contient du H2O2 et de l'eau, comprenant
• a u moins deux chambres d'évaporation (1) contiguës, conçues pour recevoir un liquide à évaporer (7), choisi parmi l'eau et une solution aqueuse de peroxyde d'hydrogène à une concentration comprise entre 0,1 g/l et 500 g/l, dans chacune desquelles la température peut être régulée séparément,
les au moins deux chambres d'évaporation (1) étant découplées thermiquement l'une de l'autre par une isolation thermique (17) qui entoure l'unité de régulation de la température (2) de chaque chambre d'évaporation (1) et
les chambres d'évaporation (1) étant segmentées chacune dans un sens d'installation horizontal par le fait que chaque chambre d'évaporation (1) comporte au moins une paroi verticale (8) munie d'une ouverture;
• une unité de régulation de la température (2) sur chacune des chambres d'évaporation (1), laquelle unité de régulation de la température (2) est conçue comme un bain-marie thermostaté et comporte un bac et un couvercle qui ferme le bac et dont la température peut être régulée; et
• des conduites de gaz qui relient une alimentation en gaz porteur (15) à la première chambre d'évaporation (1) et qui relient les autres chambres d'évaporation (1) entre elles successivement et qui offrent un échappement (12) au niveau de la dernière chambre d'évaporation (1) de sorte que, pendant l'utilisation, le gaz porteur est acheminé à travers la première chambre d'évaporation (1) puis successivement à travers les autres, le long de la surface d'un liquide à évaporer (7) qui se trouve dans les chambres d'évaporation (1).

2. Dispositif selon la revendication 1, comprenant au moins trois chambres d'évaporation (1).

3. Dispositif selon l'une des revendications 1 ou 2, dans lequel les chambres d'évaporation (1) ont une longueur de 200 mm au maximum.

4. Dispositif selon l'une des revendications 1 bis 3, dans lequel le matériau de paroi intérieure des chambres d'évaporation (1) est choisi parmi le verre, le polytétrafluoroéthylène, l'acier inoxydable et la céramique.

5. Dispositif selon l'une des revendications 1 à 4, comprenant
• un capteur de pression (6) pour mesurer la pression ambiante et/ou la pression du gaz porteur à son entrée dans le dispositif et
• un régulateur de pression (13) pour compenser la pression ambiante qui change et/ou cette pression de gaz porteur.

6. Dispositif selon l'une des revendications 1 à 5, comprenant un capteur de gaz colorimétrique à électrolyte solide (5) pour surveiller le bon fonctionnement.

7. Procédé pour la production de mélanges gazeux composés d'un gaz porteur et d'une vapeur de liquide, laquelle vapeur de liquide contient du H2O2 et de l'eau, comprenant les étapes suivantes:
a) réglage de la température d'équilibre du mélange gazeux à produire comme valeur de consigne dans une dernière d'au moins deux chambres d'évaporation (1) dont la température peut être régulée séparément et qui sont découplées thermiquement l'une de l'autre par une isolation thermique (17) entourant les unités de régulation de la température (2) de chaque chambre d'évaporation (1), les chambres d'évaporation (1) étant segmentées dans un sens d'installation horizontal par le fait que chaque chambre d'évaporation (1) comporte au moins une paroi verticale (8) munie d'une ouverture et les unités de régulation de la température (2) étant conçues comme un bain-marie thermostaté et comprenant un bac et un couvercle qui ferme le bac et dont la température peut être régulée,
b) réglage d'une différence de température de 5 K au maximum entre des chambres d'évaporation (1) voisines, la température dans la première chambre d'évaporation (1) étant la plus basse et celle de la deuxième chambre d'évaporation (1) étant la plus élevée et celle de la troisième chambre d'évaporation (1) étant intermédiaire et correspondant à la température d'équilibre du mélange gazeux, et
c) acheminement d'un gaz porteur à un débit volumique compris entre 0 et 2 l/min dans des conditions normalisées à travers la première chambre d'évaporation (1) puis successivement à travers les autres, le long de la surface d'un liquide à évaporer (7) qui se trouve dans les chambres d'évaporation (1), dans lequel le liquide à évaporer (7) est choisi parmi l'eau et une solution aqueuse de peroxyde d'hydrogène à une concentration comprise entre 0,1 g/l et 500 g/l, et
dans lequel le liquide à évaporer qui se trouve dans la première chambre d'évaporation (1) est de l'eau et celui des autres chambres d'évaporation (1) un mélange d'eau et de H2O2.

8. Procédé selon la revendication 7, dans lequel la différence de température dans l'étape b) est de 0,01 à 4,5 K.

9. Procédé selon l'une des revendications 7 ou 8, dans lequel la température d'équilibre réglée dans l'étape a) est de 30 °C au maximum et le débit volumique du gaz porteur dans l'étape c) est de < 1 l/min dans des conditions normalisées.

10. Utilisation du dispositif selon l'une des revendications 1 à 6 pour la production de mélanges gazeux composés d'un gaz porteur et de vapeur de liquide, dans lequel la vapeur de liquide contient du H2O2 et de l'eau.

11. Utilisation du dispositif selon l'une des revendications 1 à 6 pour la production décentralisée de mélanges gazeux définis composés d'un gaz porteur et de vapeur de liquide, dans lequel la vapeur de liquide contient du H2O2 et de l'eau, pour des processus chimiques, pour l'étalonnage de capteurs de gaz en médecine, dans l'industrie pharmaceutique, dans les analyses environnementales et dans les technologies de revêtement.
